# EUROPEAN PATENT APPLICATION

(11) **EP 1 345 274 A2**
(43) Date of publication of application: **17.09.2003**
(21) Application number: 03005235.1
(22) Date of filing: 10.03.2003
(51) Int. Cl.: H01L 31/0203, H01L 33/00

(54) **Photo-detecting device, photo-emitting device and optical wireless communication device**

(30) Priority: 11.03.2002 JP 2002065230
(71) Applicant: HONDA GIKEN KOGYO KABUSHIKI KAISHA, Minato-ku Tokyo (JP); Stanley Electric Co., Ltd., Meguro-ku Tokyo (JP)
(72) Inventor: Kawabe, Koji, 4-1 Chuo, 1-chome,Wako-shi, Saitama-ken (JP); Furukawa, Yoshiki, Hadano-shi, Kanagawa-ken (JP); Yokayama, Hiroki, Hadano-shi, Kanagawa-ken (JP); Oka, Hiroyuki, 1-chome, Aoba-ku, Yokohama-shi, Kanagawa (JP); Ushida, Daisuke, Machida-shi, Tokyo (JP); Hirosawa, Kazunori, Hadano-shi, Kanagawa-ken (JP); Hibiya, Kazuyoshi, Odawara-shi, Kanagaawa-ken (JP)
(74) Representative: Weiss, Peter, Dr.

(57) **Abstract**

An optical communication device having features such as: a simple structure, easily mountable, less restrictions in arrangement designing, easy to attain compact arrangement, a mechanical sturdiness and a stable wide directional angle, is constituted as follows. A plurality of LED lamps as photo-emitting elements are mounted on a base plane with a predetermined angle inclined around long axe of the respective LED lamps and the long axe of the LED lamps are arranged so as to dived a circle on the base plane equally.

## Description

### BACKGROUND OF THE INVENTION

### 1. Field of the Invention

The present invention relates to a photo-detecting device, a photo-emitting device and an optical wireless communication device suitable for optical wireless communication of a mobile object or the like which requires to set a wide photo-detecting or photo-emitting directional angle.

### 2. Brief Description of the Related Art

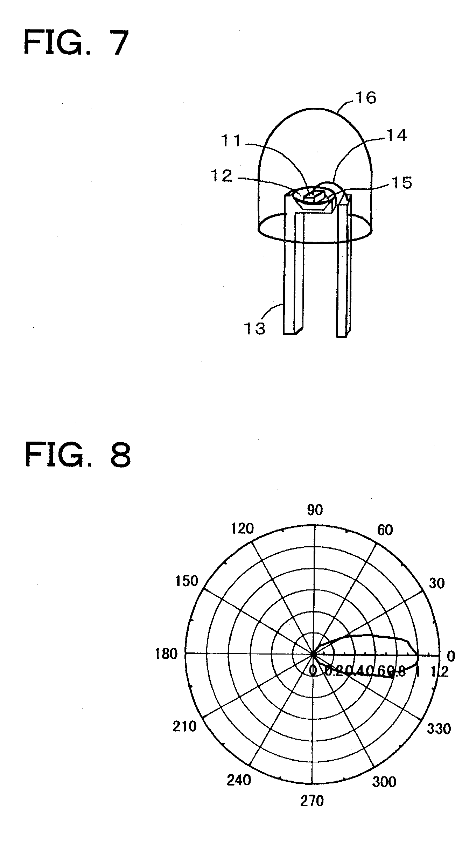

FIG.7 is a perspective view illustrating a structure of a most fundamental LED lamp. In this figure, a reference numeral "11" is an LED chip. A reference numeral "12" is a horn surrounding the LED chip 11 and forms a portion of lead frame 13. A reference numeral "14" is a bonding wire connecting the LED chip 11 to the lead frame 13. A reference numeral "15" is a conductive adhesive for fixing the LED chip 11 to the horn 12. A reference numeral "16" is a plastic lens enveloping the LED chip 11 and the horn 12.

The LED lamp constituted in the above-mentioned way is widely used for displays, illuminations and the like as well as for optical wireless communication. FIG.8 shows a typical photo-distributing pattern of the LED lamp.

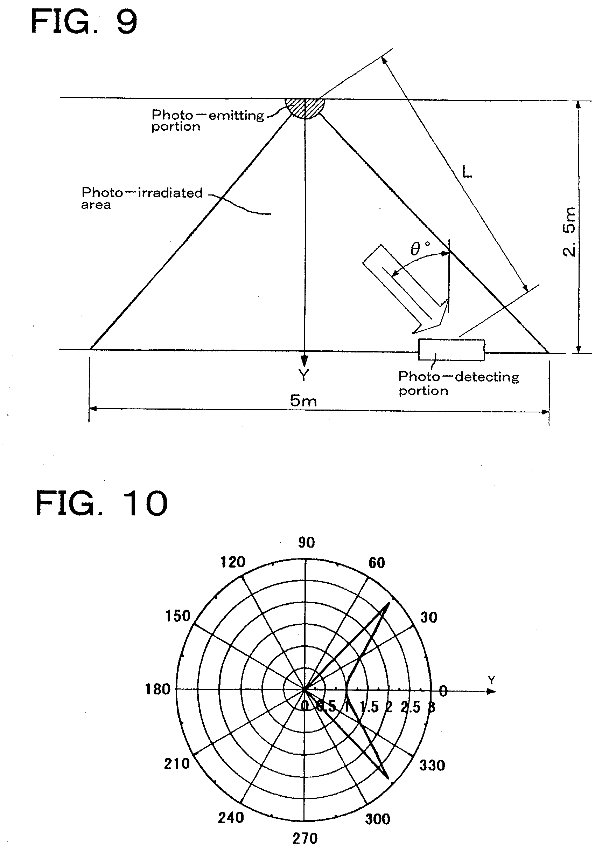

Here let's assume a situation that a wide directional angle for a optical wireless communication as shown in FIG.9 is attained by utilizing LED lamps having the above-mentioned photo-distributing characteristic. FIG.9 shows a target example of the wide directional angles for the optical wireless communication, where a height from a photo-emitting portion to a photo-receiving plane is 2.5m. A distance between the photo-emitting portion and a photo-detecting portion is set L and the photo-receiving plane having a diameter of 5m, which forms a symmetrical conical service area around an axis Y.

Peripheral areas of the conical service area in FIG.9 require the following conditions compared with an area just under the photo-emitting portion.
1) The further the photo-receiving plane is located from the photo-emitting portion, the more photo-emitting power proportional to a square value of a distance between the photo-emitting portion and the photo-receiving plane is required in order to keep the same communication status regardless of a relative position between the photo-emitting portion and the photo-receiving plane.
2) When a front (a photo-receiving front) of the photo-detecting portion is placed to face normally to the photo-receiving plane and no special lenses are arranged at the photo-detecting portion, a sensitivity of the photo-detecting portion is proportional to a value of cos θ (θ is an angle formed between a normal line to the photo-receiving plane and a line from the photo-emitting portion to photo-detecting portion). Therefore an irradiated power should be increased by a value proportional to the reciprocal of cos θ in order to keep the same transfer quality as that of the area just under the photo-emitting area.

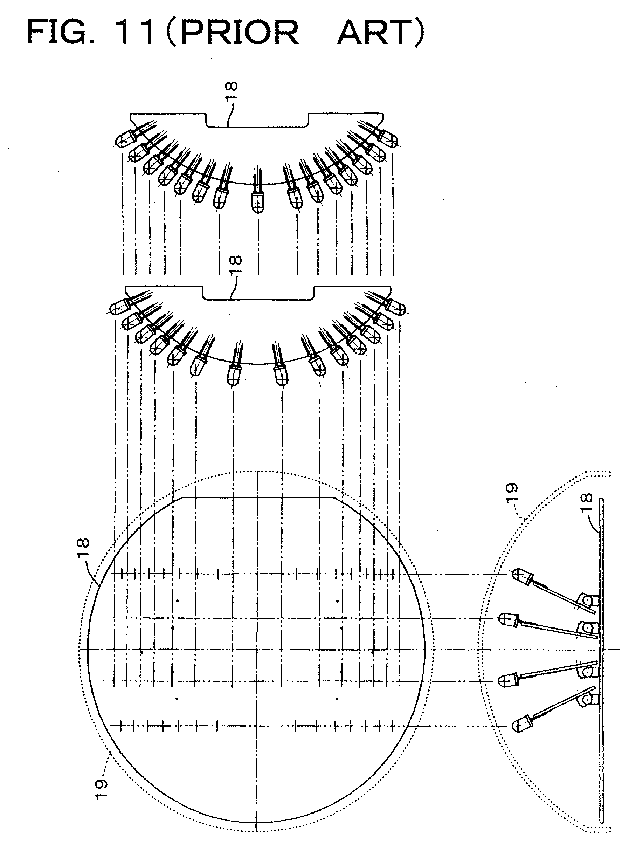

If conditions 1) and 2) are fulfilled, an ideal photo-distributing pattern as shown in FIG.10 will be obtained. FIG.11 shows a device arrangement example constituted by a plurality of devices (LED lamps) for realizing the ideal photo-distribution pattern. In the figure, a reference numeral "18" is a base plate on which LED lamps are mounted and a reference numeral "19" is a transparent front cover.

Since a photo-distributing area attained by one LED lamp is too narrow compared with the target photo-distributing area, it is necessary to arrange a plurality of LED lamps in a shape like a pincushion so as to realize a wide photo-distributing area. When respective LED lamps have the same photo-emitting powers, it is necessary to arrange LED lamps as many as possible around peripheral portions as shown in FIG.11.

However, in the device arrangement shown in FIG.11, a plurality of LED lamps are arranged like a hedgehog. Since this arrangement shows a quite complicated structure, it is difficult to mount LED lamps and degrees of freedom in designing the device arrangement are restricted, as a result it is difficult to obtain a compact device arrangement.

Optical axes of respective LED lamps supported by leads of LED lamps are mechanically feeble. In other words since these leads are easily deformed during and after mounting LED lamps, it is difficult to obtain a stable photo-distributing pattern.

### SUMMARY OF THE INVENTION

The present invention is carried out in view of the above-mentioned problems so as to provide a photo-detecting device, a photo-emitting device and optical wireless communication device respectively having wide and stable photo-distributing pattern. Further, devices by the present invention respectively have simple and mechanically strong structures, and can be easily mounted with less restrictions in designing. Consequently, a thinner and more compact photo-detecting/emitting device can be obtained by the present invention.

The photo-detecting device, the photo-emitting device and optical wireless communication device by the present invention are constituted as follows.
(1) A photo-detecting device comprising: a plurality of photo-detecting elements; a plurality of bases on which a plurality of photo-detecting elements are mounted; and a base plate on which the mounted bases are arranged, wherein: each base is mounted on the base plate with inclination, a main axis of each photo-detecting element is arranged in a desired direction which is substantially normal to the base.
(2) The photo-detecting device according to (1), wherein: a plurality of photo-detecting elements are mounted on the base plate such that the main axis of each photo-detecting element is arranged with an equal angular pitch.
(3) A photo-emitting device comprising: a plurality of photo-emitting elements; a plurality of bases on which a plurality of photo-emitting elements are mounted; and a base plate on which the mounted bases are arranged, wherein: each base is mounted on the base plate with inclination, a main axis of each photo-emitting element is arranged in a desired direction which is substantially normal to the base.
(4) The photo-detecting device according to (3), wherein: a plurality of photo-emitting elements are mounted on the base plate such that the main axis of each photo-emitting element is arranged with an equal angular pitch.
(5) An optical wireless communication device equipped with the photo-detecting device according to (1) or (2).
(6) An optical wireless communication device equipped with the photo-emitting device according to (3) or (4).
(7) An optical wireless communication device equipped with the photo-detecting device according to (1) or (2) and the photo-emitting device according to (3) or (4).
(8) A photo-emitting device comprising: a plurality of photo-emitting elements; and a base plate on which the plurality photo-emitting elements are arranged so as to have different emitting directions each other, wherein: the plurality of photo-emitting elements are arranged such that an emitting power in a direction with a deviated angle θ from a normal line to the base plate is set (1/cos θ) squared times as intense as the emitting power in the normal direction to the base plate.
(9) The photo-emitting device according to (8), wherein: the photo-emitting element has a plurality of LED chips.
(10) The photo-emitting device according to (8) or (9), wherein: the photo-emitting elements are arranged on the base plate radially with equal angular pitch.
(11) A photo-detecting device comprising: a plurality of photo-detecting elements; and a base plate on which the plurality photo-detecting elements are arranged so as to have different detecting directions each other, wherein: the plurality of photo-detecting elements are arranged such that a detecting sensitivity in a direction with a deviated angle θ from a normal line to the base plate is set (1/cos θ) squared times as high as the detecting sensitivity in the normal direction to the base plate.
(12) The photo-detecting device according to (11), wherein: the photo-detecting element has a plurality of photo-detecting chips.
(13) The photo-detecting device according to (11) or (12), wherein: the photo-detecting elements are arranged on said base plate radially with equal angular pitch.
(14) An optical wireless communication device comprising at least one of photo-emitting devices according (8) to (10) and photo-detecting devices according to (11) to (13).

### BRIEF DESCRIPTION OF THE DRAWINGS

FIG.1 is a perspective view illustrating a structure of LED by an embodiment of the present invention.
FIG.2A is a perspective view illustrating a member for attaching the LED lamp. FIG.2B is a sectional view of the member shown in FIG.2A.
FIG.3 is a plane view illustrating an arrangement of a plurality of LED lamps.
FIG.4 shows other arrangement of a plurality of LED arrangement.
FIGs.5A and 5B show an example of arrayed LED lamps. FIG.5A is a side view and FIG.5B is a front view.
FIG.6 is a plan view illustrating an arrangement constituted by a plurality of the arrayed LED lamps in FIGs.5A and 5B.
FIG.7 is a perspective view illustrating a structure of a fundamental LED lamp.
FIG.8 shows a typical photo-distributing pattern of the LED lamp.
FIG.9 is an explanatory view illustrating a wide directional communication area to be attained.
FIG.10 shows an ideal photo-distributing pattern of the wide directional communication area in FIG.9.
FIG.11 is a conventional arranging example of LED lamps for attaining the ideal photo-distributing pattern shown in FIG.10.

### DETAILED DESCRIPTION OF THE PREFERRED EMBODIMENTS.

Hereinafter, embodiments by the present invention are explained by referring to the drawings. The embodiments can realize stable wide photo-detecting and photo-emitting directional angles with compact arrangements for being employable in optical wireless communication.

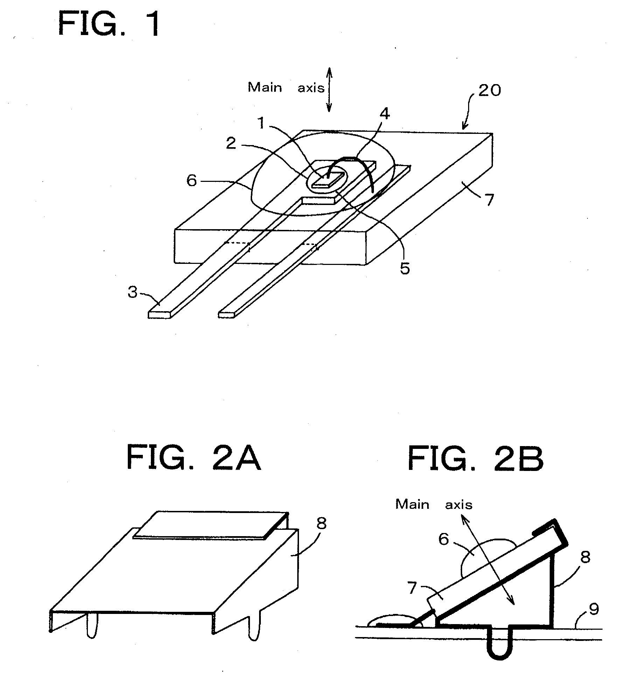

FIG.1 is the perspective view illustrating the structure of an LED lamp 20 by the present invention. In the figure, a reference numeral "1" is an LED chip for mounting on the LED lamp 20. A reference numeral "2" is a horn surrounding the LED chip 1. A reference numeral "3" is lead frames made of an iron wire or a copper wire. A reference numeral "4" is a bonding wire connecting the LED chip 1 to one of the lead frames 3. A reference numeral "5" is conductive adhesive for fixing the LED chip 1 to other lead frame 3. A reference numeral "6" is a transparent plastic lens which covers the LED chip 1 and a front face of the horn 2. A reference numeral "7" is a base on which the LED chip 1 and lead frames 3 are mounted. Here a photo-emitting direction of the LED chip is referred as a main axis, which is substantially normal to the base 7.

In the present embodiment, LED lamps 20 are mounted on a base plate 9 (which will be explained afterward) with a inclination and the main axis of each LED chips 1 are arranged so as to extend in a desired direction..

In order to attain the above-mentioned arrangement LED chip 1 is formed a device (photoelectric conversion element) mountable on a plane. Since the base 7 is fixed together with the LED chip 1 by a resin, a stable photo-emitting direction is maintained.

FIGs.2A and 2B show the member for attaching the LED lamp 20 to stabilize the inclined fixed angles to the base plate 9. FIG.2A is the perspective view illustrating a member 8 for attaching the LED lamp 20 to the base plate 9. FIG.2B is the sectional view of the member 8 attached to the base plate 9. The inclined fixed angles are determined according to required photo-emitting directional angles.

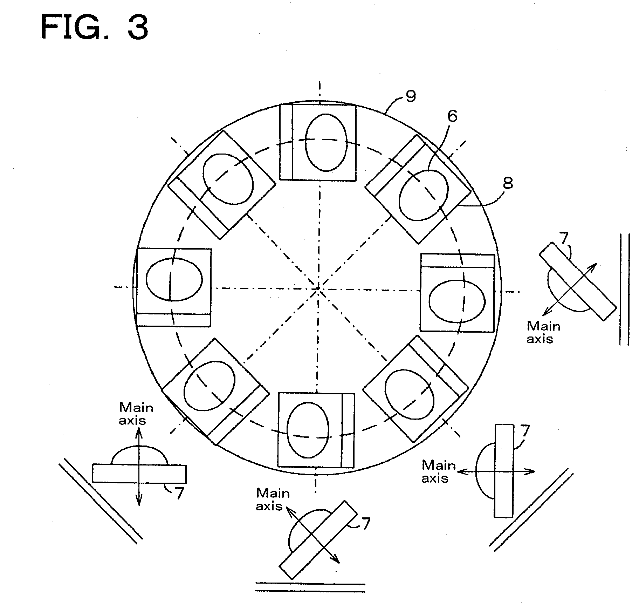

FIG.3 shows the arranged example of a plurality of LED lamps. Respective LED lamps 20 are arranged such that lines from the respective LED chips 1 parallel to lead frames of the LED lamps 20 extend radially and equally divide a circular space above the base plate 9. The LED lamps 20 mounted on bases 7 are arranged with the predetermined inclined angle and arranged circularly with an equal angular pitch on the base plate 9 (a propeller arrangement), so that the main axe of respective LED lamps 20 extend in different directions each other. Thus the ideal photo-distributing pattern is relatively easily attained.

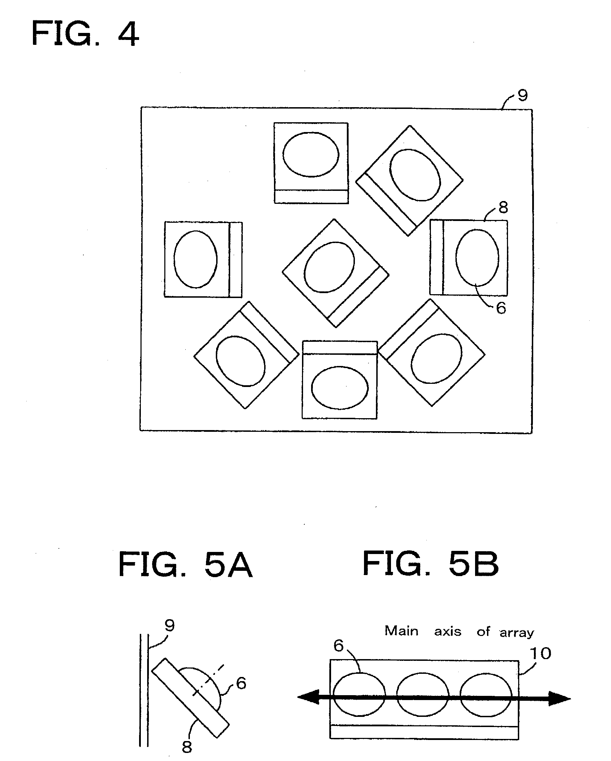

In the above-described embodiment, n (n is a positive integer more than three) pieces of devices (LED lamps) are arranged radially with the equal angular pitch, but positions to be arranged are not specified. However, LED lamps can be freely arranged as far as a certain LED lamp does not disturb photo-emitting directions of the other LED lamps. In this case the base plate 9 can be formed in a smaller size and LED lamp can be arranged so as to avoid parts which may disturb photo-emitting directions of the LED lamps. One such arranged example of a plurality of LED lamps is shown in FIG.4.

If a photo-emitting power is not enough by one LED lamp, the arrayed device 10 (light source) shown in FIGs.5A and 5B can be employed instead. FIG.5A is the side view of the arrayed device and FIG.5B is the plan view of the arrayed device. When respective LED lamps on the arrayed device 10 are arranged so as to emit in the same direction, an enough photo-emitting power is obtained.

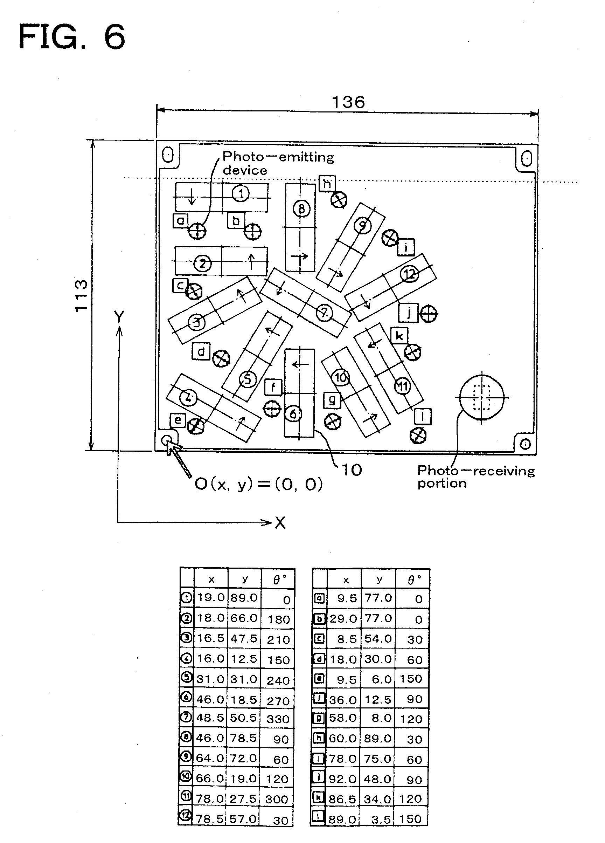

FIG. 6 is the arranging example constituted by the arrayed devices. In this example, a left and down side hole of a base plate is set as a reference point (the origin) of the coordinates X and Y. Arranged positions and angles for respective arrayed devices are shown in attached table to FIG.6. θ in the table is an angle revolved counterclockwise from X coordinate. Alphabetical characters a to 1 in FIG.6 represent individual photo-emitting devices. Photoemitting devices a to 1 are arranged among the arrayed devices 10 in order to supplement a photo-emitting distribution pattern by the arrayed devices 10, thus a desired ideal photo-distribution pattern is attained in a limited space.

As described above, the present embodiment has a simple structure and devices are easily and freely mounted so as to avoid disturbing objects of photo-emitting directions of these devices. There are less restrictions in designing arrangements of devices so that a compactly arranged product is easily obtained. In addition, products having strong mechanical properties and stable wide directional photo-distributing properties can be obtained.

In the above embodiments, embodiments which employ photo-emitting devices are explained, but a photo-detecting device having an excellent wide directional angle by utilizing photo-receiving elements such as photodiodes can be constituted in the same way as the photo-emitting devices.

Either of photo-emitting devices or photo-detecting devices or both devices may constitute a wireless communication system. In the wireless communication system, photo-detecting devices may be used as mobile devices or photo-detecting and photo-emitting devices can relatively change their positions. Arranging pitches of photo-detecting/emitting devices and a relative moving speed between the photo-detecting device and photo-emitting device are properly determined according to photo-detecting/emitting abilities, utilizing circumstances and the like. Since a transmission speed of an optical communication is sufficiently large, bad influences caused by a signal displacement due to a properly arranged distance between the photo-detecting device and photo-emitting device, are negligibly small.

Other devices except LED (Light Emitting Diode) are applicable as a photo-emitting element. The inclined angle of each LED lamp 20 against the base plate, each main axis of each LED lamp normal to each base, the number of devices and the like are properly selected according to a photo-emitting power of the LED and a photo-detecting ability of the photo-detecting portion, a circumstance where the optical wireless communication devices is applied, a distance between the photo-emitting portion and the photo-detecting portion, a relative speed between two photo-detecting devices and the like, so that the ideal photo-distributing pattern shown in FIG.10 can be attained by the present invention.

As explained above, the present invention attains the following effects. Devices with a simple structure are obtained. Devices are easily mounted, device arrangements are designed with less restrictions. Compactly mounted devices are obtained. Mechanically sturdy devices are obtained and stable wide directional photo-distributing patterns are obtained.

## Claims

1. A photo-detecting device comprising:
a plurality of photo-detecting elements;
a plurality of bases on which said plurality of photo-detecting elements are mounted; and
a base plate on which said mounted bases are arranged, wherein:
each base is mounted on the base plate with inclination, and
a main axis of each said photo-detecting element is arranged in a desired direction which is substantially normal to the base.

2. The photo-detecting device according to claim 1, wherein:
said plurality of photo-detecting elements are mounted on said base plate such that said main axis of each said photo-detecting element is arranged with an equal angular pitch.

3. A photo-emitting device comprising:
a plurality of photo-emitting elements;
a plurality of bases on which said plurality of photo-emitting elements are mounted; and
a base plate on which said mounted bases are arranged, wherein:
each base is mounted on the base plate with inclination, and
a main axis of each said photo-emitting element is arranged in a desired direction which is substantially normal to the base.

4. The photo-detecting device according to claim 1, wherein:
said plurality of photo-emitting elements are mounted on said base plate such that said main axis of each said photo-emitting element is arranged with an equal angular pitch.

5. An optical wireless communication device equipped with the photo-detecting device according to claim 1 or claim 2.

6. An optical wireless communication device equipped with the photo-emitting device according to claim 3 or claim 4.

7. An optical wireless communication device equipped with the photo-detecting device according to claim 1 or claim 2 and the photo-emitting device according to claim 3 or claim 4.

8. A photo-emitting device comprising:
a plurality of photo-emitting elements; and
a base plate on which said plurality photo-emitting elements are arranged so as to have different emitting directions each other, wherein:
said plurality of photo-emitting elements are arranged such that an emitting power in a direction with a deviated angle θ from a normal line to said base plate is set (1/cos θ) squared times as intense as the emitting power in the normal direction to said base plate.

9. The photo-emitting device according to claim 8, wherein:
said photo-emitting element has a plurality of LED chips.

10. The photo-emitting device according to claim 8 or claim 9, wherein:
said photo-emitting elements are arranged on said base plate radially with equal angular pitch.

11. A photo-detecting device comprising:
a plurality of photo-detecting elements; and
a base plate on which said plurality photo-detecting elements are arranged so as to have different detecting directions each other, wherein:
said plurality of photo-detecting elements are arranged such that a detecting sensitivity in a direction with a deviated angle θ from a normal line to said base plate is set (1/cosθ) squared as high as the detecting sensitivity in the normal direction to said base plate.

12. The photo-detecting device according to claim 11, wherein:
said photo-detecting element has a plurality of photo-detecting chips.

13. The photo-detecting device according to claim 11 or claim 12, wherein:
said photo-detecting elements are arranged on said base plate radially with equal angular pitch.

14. An optical wireless communication device comprising at least one of photo-emitting devices according claims 8 to 10 and photo-detecting devices according to claims 11 to 13.
